# EUROPEAN PATENT APPLICATION

(11) **EP 4 641 623 A1**
(43) Date of publication of application: **29.10.2025**
(21) Application number: 24866769.3
(22) Date of filing: 22.02.2024
(51) Int. Cl.: H01L 21/50, H01L 21/56, H01L 21/60, H01L 23/498, H01L 25/16, G02B 6/122

(54) **PHOTOELECTRIC INTEGRATED SEMICONDUCTOR PACKAGING STRUCTURE AND MANUFACTURING METHOD THEREFOR**

(30) Priority: 21.09.2023 CN 202311229870
(71) Applicant: SJ Semiconductor (Jiangyin) Corporation, Jiangyin City Wuxi, Jiangsu 214437 (CN)
(72) Inventor: CHEN, Yenheng, Wuxi, Jiangsu 214437 (CN); LIN, Chengchung, Wuxi, Jiangsu 214437 (CN)
(74) Representative: Canzler & Bergmeier Patentanwälte Partnerschaft mbB
(86) International application number: PCT/CN2024/078027
(87) International publication number: WO 2025/060342

(57) **Abstract**

The present invention provides a photoelectric integrated semiconductor packaging structure and a manufacturing method therefor. By means of a TSV base, a substrate, a rewiring layer, an optical waveguide wiring layer, and a micro-mirror, an optical chip and an electrical chip are packaged. In this way, the stacked interconnection and interlaced routing of electrical signal wiring and optical signal wiring can be achieved, thereby reducing the packaging area, increasing the wiring density, effectively shortening transmission paths of optical signals and electrical signals, reducing signal attenuation, and meeting the requirements of high-density integrated packaging.

## Description

### FIELD OF TECHNOLOGY

The present disclosure relates to the field of semiconductor packaging, and in particular, relates to an optoelectronic integrated semiconductor packaging structure and a method for manufacturing the same.

### BACKGROUND

With the continuous development of big data, artificial intelligence, telemedicine, Internet of Things, e-commerce and 5G communication, the global data traffic grows explosively, and lower cost, more reliable, faster and higher density circuits are the pursuit of integrated circuit packaging.

To meet the demand of Internet traffic, the bandwidth of data center nodes needs to reach 10 Tb/s, and to alleviate the trend of increasing energy consumption of data centers, it is necessary to reduce the power consumption of systems and devices. Driven by ultra-high data capacity, traditional electrical chip manufacturing processes are gradually approaching 10nm dimensions, and CMOS technology is nearing its physical limits. The industry is attracted by the advantages of light, such as low signal attenuation, low energy consumption, high bandwidth, and compatibility with CMOS processes, it is generally believed that integrating silicon photonic chips with mature microelectronic and optoelectronic technologies will not only reduce chip size, cost, and power consumption, but also improve chip reliability, making it a promising high-speed information engine for "More than Moore". Therefore, the introduction of silicon photonic technology is essential. Since the purpose of introducing silicon photonic technology is to increase input/output (I/O) bandwidth and minimize energy consumption, how photonic integrated circuits (PICs) and electronic integrated circuits (EICs) are packaged together is very crucial, as these factors will directly affect I/O bandwidth and energy consumption.

Most of the existing optoelectronic integrated semiconductor packaging structures have the optical integrated chip and the electrical integrated chip bonded directly to the base substrate, and the packaging structures are electrically connected to the base substrate by wire-bonds or Flip-Chip. Since the silicon optical process node is relatively behind respect to the electrical chip, for example, the silicon optical process nodes currently developed by monolithic integration use 45 nm and 32 nm processes, which is far different from the process nodes below 10 nm of the electrical chip, so it is difficult for the existing optoelectronic integrated semiconductor packaging structure to meet the requirements of high-density integrated packaging.

Therefore, it is necessary to provide an optoelectronic integrated semiconductor packaging structure and a method for manufacturing the same.

### SUMMARY

The present disclosure provides an optoelectronic integrated semiconductor packaging structure and a method for manufacturing the same, thus performing high-density integrated packaging on an optical chip and an electrical chip.

The method for manufacturing the optoelectronic integrated semiconductor packaging structure comprises:
providing a TSV substrate having a TSV (through silicon via) metal pillars, the first end of the TSV metal pillar is exposed from the first surface of the TSV substrate;
forming a first redistribution layer on the first surface of the TSV substrate, and the first redistribution layer is electrically connected to the first end of the TSV metal pillar;
forming a patterned optical waveguide wiring layer, micro-mirrors, and forming a second redistribution layer on the first redistribution layer, wherein the second redistribution layer is electrically connected to the first redistribution layer, the optical waveguide wiring layer is disposed next to the micro-mirrors, and part of the second redistribution layer covers the optical waveguide wiring layer but it does not cover the micro-mirrors;
providing a first supporting substrate, and bonding the second redistribution layer to the first supporting substrate;
thinning the second surface of the TSV substrate to expose a second end of the TSV metal pillar;
forming a third redistribution layer on the thinned second surface of the TSV substrate; the third redistribution layer is electrically connected to the second end of the TSV metal pillar;
forming first metal bumps on the third redistribution layer; the first metal bumps are electrically connected to the third redistribution layer;
removing the first supporting substrate, providing a second supporting substrate, and bonding the first metal bumps to the second supporting substrate;
bonding an electrical chip and an optical chip on the second redistribution layer; both the electrical chip and the optical chip are electrically connected to the second redistribution layer, and a photosensitive region of the optical chip is disposed aligned to the micro-mirrors;
removing the second supporting substrate, providing a base substrate, bonding the first metal bumps to the base substrate, and electrically connecting the base substrate to the first metal bumps;
providing a connector, and bonding the connector to the base substrate; the connector is disposed attached to the optical waveguide wiring layer.

Optionally, a method of forming the micro-mirrors comprises a semiconductor exposure and development patterning method or a bonding method.

Optionally, when the micro-mirrors are manufactured by a semiconductor exposure and development patterning method, the micro-mirrors are formed simultaneously with the second redistribution layer.

Optionally, a method for forming the optical waveguide wiring layer comprises a semiconductor exposure and development method, and the materials of the formed optical waveguide wiring layer comprises an organic polymer optical waveguide wiring layer, a silicon-based optical waveguide wiring layer, a lithium niobate optical waveguide wiring layer, or a lithium borate optical waveguide wiring layer.

Optionally, the method further comprises a step of providing a heat dissipation member and bonding the heat dissipation member, wherein the bonded heat dissipation member is in direct or indirect contact with the electrical chip and/or the optical chip.

Optionally, after removing the second supporting substrate, the method further comprises a step of wafer dicing.

Optionally, a first underfill layer fills a gap between the electrical chip, the optical chip and the second redistribution layer; and a second underfill layer fills a gap between the third redistribution layer and the base substrate.

Optionally, the first redistribution layer comprises a damascene redistribution layer; the second redistribution layer comprises an organic redistribution layer; and the third redistribution layer comprises an organic redistribution layer.

The present disclosure further provides an optoelectronic integrated semiconductor packaging structure, comprising:
a TSV substrate comprising a TSV metal pillar, the first end of the TSV metal pillar is exposed from the first surface of the TSV substrate and the second end of the TSV metal pillar is exposed from the second surface of the TSV substrate;
a first redistribution layer; the first redistribution layer is located on the first surface of the TSV substrate, and the first redistribution layer is electrically connected to the first end of the TSV metal pillar;
a patterned optical waveguide wiring layer on the first redistribution layer;
micro-mirrors located on the first redistribution layer; the optical waveguide wiring layer is disposed next to the micro-mirrors;
a second redistribution layer located on the first redistribution layer and electrically connected to the first redistribution layer, and the second redistribution layer covers the optical waveguide wiring layer but it does not cover the micro-mirrors;
a third redistribution layer; the third redistribution layer is located on the second surface of the TSV substrate, and the third redistribution layer is electrically connected to the second end of the TSV metal pillar;
first metal bumps; the first metal bumps are located on the third redistribution layer and are electrically connected to the third redistribution layer;
an electrical chip and an optical chip; the electrical chip and the optical chip are both bonded on the second redistribution layer, the electrical chip and the optical chip are both electrically connected to the second redistribution layer, and a photosensitive region of the optical chip is disposed aligned to face the micro-mirrors;
a base substrate bonded to the first metal bumps and electrically connected to the first metal bumps;
a connector bonded to the base substrate and disposed attached to the optical waveguide wiring layer.

Optionally, a heat dissipation member is further comprised, and the heat dissipation member is in direct or indirect contact with the electrical chip and/or the optical chip.

As described above, in the optoelectronic integrated semiconductor packaging structure and the method for manufacturing the same of the present disclosure, the optical chip and the electrical chip are packaged through the TSV substrate, the first and second supporting substrates, the first, second and third redistribution layers, the optical waveguide wiring layer and the micro-mirrors, so that the electrical signal wiring and the optical signal wiring can be stacked and interconnected and staggered to reduce the packaging area, increase the wiring density, effectively shorten the transmission path of the optical signal and the electrical signal, reduce the signal attenuation, and meet the requirements of high-density integrated packaging.

### BRIEF DESCRIPTION OF THE DRAWINGS

FIG. 1 is a process flow chart for manufacturing an optoelectronic integrated semiconductor packaging structure according to an embodiment of the present disclosure.
FIG. 2 is a schematic structural diagram after a first redistribution layer is formed according to an embodiment of the present disclosure.
FIG. 3 is a schematic structural diagram after an optical waveguide wiring layer, micro-mirrors and a second redistribution layer are formed according to an embodiment of the present disclosure.
FIG. 4 is a schematic structural diagram after a first supporting substrate is formed according to an embodiment of the present disclosure.
FIG. 5 is a schematic structural diagram after forming first metal bumps according to an embodiment of the present disclosure.
FIG. 6 is a schematic structural diagram after a second supporting substrate bonded to a first supporting substrate is removed according to an embodiment of the present disclosure.
FIG. 7 is a schematic structural diagram after an electrical chip and an optical chip are bonded according to an embodiment of the present disclosure.
FIG. 8 is a schematic structural diagram after bonding with a substrate and forming second metal bumps according to an embodiment of the present disclosure.
FIG. 9 is a schematic structural diagram after a connector is bonded according to an embodiment of the present disclosure.
FIG. 10 is a schematic structural diagram after a heat dissipation member is bonded according to an embodiment of the present disclosure.

### Reference Numerals

100- TSV substrate; 200 -TSV metal pillar; 310-First redistribution layer; 320-Second redistribution layer; 330-Third redistribution layer; 400-Optical waveguide wiring layer; 500-Micro-mirrors; 610-First supporting substrate; 620-Second supporting substrate; 611-First separation layer; 621-Second separation layer; 710-First metal bumps; 720-Second metal bumps; 810-Electrical chip; 820-Optical chip; 821-Photosensitive region; 910-First underfill layer; 920-Second underfill layer; 110-Base Substrate; 120-Connector; 130-Heat dissipation member.

### DETAILED DESCRIPTION

The embodiments of the present disclosure are described below through specific examples, and those skilled in the art can easily understand other advantages and effects of the present disclosure from the content disclosed in the specification. The present disclosure may also be implemented or applied through other different specific embodiments, and various details in the specification may also be modified or changed based on different viewpoints and applications without departing from the spirit of the present disclosure.

As in the detailed description of the embodiments of the present disclosure, for the convenience of explanation, the cross-sectional view showing the device structure will not be partially enlarged according to the general scale, and the schematic diagram is only an example, which should not limit the protection scope of the present disclosure herein. In addition, three-dimensional dimensions of length, width and depth should be comprised in actual production.

Spatially relative terms, such as "beneath," "below," "lower," "under," "above," "upper," and the like, may be used herein for ease of description to describe one element or feature's relationship to another element (s) or feature (s) as illustrated in the figures. It will be understood that these spatial relationship terms are intended to encompass other orientations of the device in use or operation in addition to the orientation depicted in the drawings, which may comprise embodiments in which the first and second features are formed in direct contact, and may also comprise embodiments in which additional features are formed between the first and second features, such that the first and second features may not be in direct contact, and additionally, when a layer is referred to as being "between" two layers, it may be the only layer between the two layers, or one or more intervening layers may also be present.

It should be noted that the drawings provided in the embodiment only illustrate the basic concept of the present disclosure in a schematic manner, so that the drawings only show the components related to the present disclosure rather than drawing according to the number, shape and size of the components in actual implementation, and the configuration, number and proportion of each component in actual implementation may be randomly changed, and the component layout configuration may also be more complex.

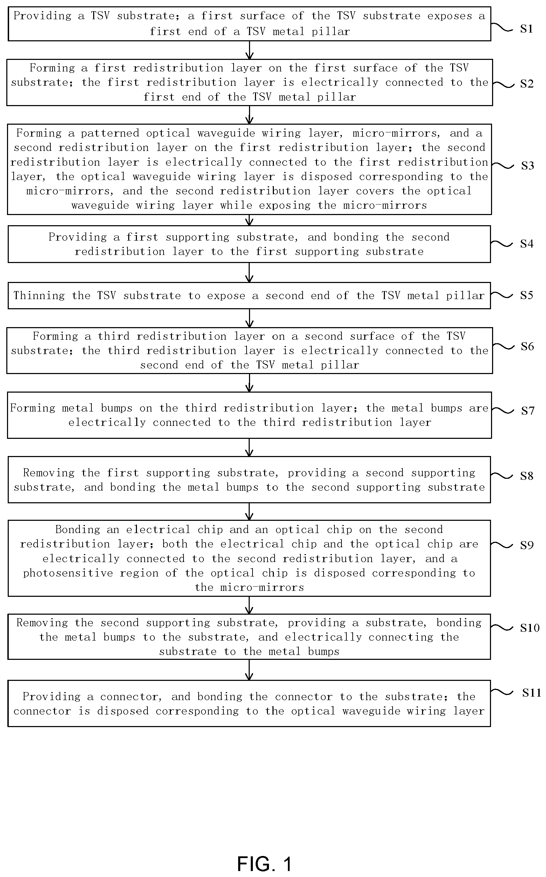

As shown in FIG. 1, this embodiment provides a method for manufacturing an optoelectronic integrated semiconductor packaging structure, in which an optical chip and an electrical chip are packaged through a TSV substrate, a base substrates, three redistribution layers, an optical waveguide wiring layer, and micro-mirrors, so that stacked interconnection and staggered wiring of electrical signal wiring and optical signal wiring can be realized, thereby reducing a packaging area, increasing wiring density, effectively shortening transmission paths of optical signals and electrical signals, reducing signal attenuation, and meeting requirements of high-density integrated packaging.

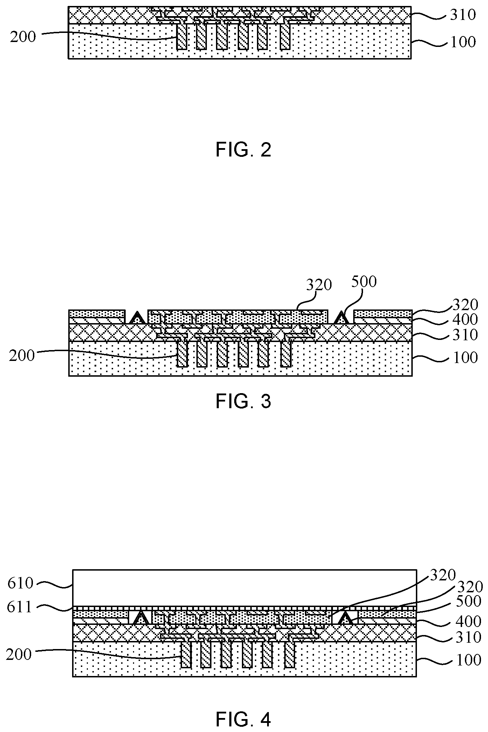

The method for manufacturing the optoelectronic integrated semiconductor packaging structure will be further described below with reference to FIGs. 2-10, which specifically comprises:
First, referring to FIG. 1 and FIG. 2, step S1 is performed to provide a TSV substrate 100 containing TSV metal pillars, where a first surface of the TSV substrate 100 exposes a first end of a TSV metal pillar 200.

Specifically, the TSV substrate 100 may comprise a wafer-level substrate with a size of 4 inches, 6 inches, 8 inches, 12 inches, etc., to further improve the process efficiency.

Then, step S2 is performed to form a first redistribution layer 310 on the first surface of the TSV substrate 100, and the first redistribution layer 310 is electrically connected to the first end of the TSV metal pillar 200.

Specifically, the first redistribution layer 310 may comprise a damascene redistribution layer. The material of the dielectric layer may comprise silicon oxide, silicon nitride, and the material of the metal wiring may comprise copper and aluminum. A smaller line width and line spacing may be obtained by the first redistribution layer 310 to meet the subsequent high-density connection requirements. The material, number of layers, layout, and fabrication method of the first redistribution layer 310 may be selected as needed.

Next, referring to FIG. 1 and FIG. 3, step S3 is performed to form a patterned optical waveguide wiring layer 400, micro-mirrors 500, and a second redistribution layer 320 on the first redistribution layer 310. The second redistribution layer 320 is electrically connected to the first redistribution layer 310. The optical waveguide wiring layer 400 is disposed corresponding to the micro-mirrors 500, so that efficient optical transmission can be performed between the optical waveguide wiring layer 400 and the micro-mirrors 500. The second redistribution layer 320 covers the optical waveguide wiring layer 400, but it does not cover the micro-mirrors 500, in order to facilitate optical transmission through the exposed micro-mirrors 500.

As an example, a method for forming the optical waveguide wiring layer 400 may comprise a semiconductor exposure and development method, and the formed optical waveguide wiring layer 400 may comprise an organic polymer optical waveguide wiring layer, a silicon-based optical waveguide wiring layer, a lithium niobate optical waveguide wiring layer or a lithium borate optical waveguide wiring layer, for example, a material of the organic polymer optical waveguide wiring layer may comprise polymethyl methacrylate (PMMA), polystyrene (PS), polycarbonate (PC) epoxy resin, fluorine-containing polyimide, etc. The material, distribution, and fabrication of the optical waveguide wiring layer 400 are not excessively limited herein.

As an example, a method for forming the micro-mirrors 500 may comprise a semiconductor exposure and development patterning method, and preferably, the micro-mirrors 500 and the second redistribution layer 320 may be formed synchronously. The micro-mirrors 500 prepared in advance may also be bonded to the first redistribution layer 310 by a bonding method.

The structure of the micro-mirrors 500 may comprise a composite structure with a polymer material or an inorganic silicon material inside and a metal material covering the surface. The material, distribution, morphology, and fabrication method of the micro-mirrors 500 are not limited herein.

As an example, the second redistribution layer 320 is preferably an organic redistribution layer, that is, the dielectric layer of the second redistribution layer 320 may comprise polyimide (PI), to facilitate the subsequent electrical connection with the chip, and when the second redistribution layer 320 is fabricated, the influence of high temperature on the optical waveguide wiring layer 400 may be avoided. The material, number of layers, layout, and fabrication method of the second redistribution layer 320 may be selected as required.

Specifically, the sequence of forming the patterned optical waveguide wiring layer 400, the micro reflector 500, and the second redistribution layer 320 on the first redistribution layer 310 may be changed according to the process selected for each component, for example, the patterned optical waveguide wiring layer 400 may be formed on the first redistribution layer 310 by a semiconductor exposure and development method first, and then the micro reflector 500 prepared in advance is attached to the first redistribution layer 310 by a bonding method, and finally the second redistribution layer 320 is formed by a semiconductor exposure and development method; of course, the micro reflector 500 prepared in advance may be attached to the first redistribution layer 310 by a bonding method, and then the optical waveguide wiring layer 400 and the second redistribution layer 320 are formed; of course, the optical waveguide wiring layer 400 may be formed first, and then the micro reflector 500 and the second redistribution layer 320 composed of the same material may be synchronously formed. A preparation sequence of the optical waveguide wiring layer 400, the micro-mirrors 500, and the second redistribution layer 320 is not excessively limited herein.

Next, referring to FIG. 1 and FIG. 4, step S4 is performed to provide a first supporting substrate 610, and bond the second redistribution layer 320 to the first supporting substrate 610.

Specifically, the first supporting substrate 610 may comprise a glass substrate, a metal substrate or a semiconductor substrate to provide support for subsequent processing steps. To facilitate subsequent removal of the first supporting substrate 610, in this embodiment, a first separation layer 611 is preferably formed on a surface of the first supporting substrate 610, and the first separation layer 611 comprises an adhesive tape and a polymer layer, for example, the first separation layer 611 may be a light-to-heat conversion layer, so that the first separation layer 611 may be subsequently heated by using, for example, laser, to remove the first supporting substrate 610, thereby improving operation convenience.

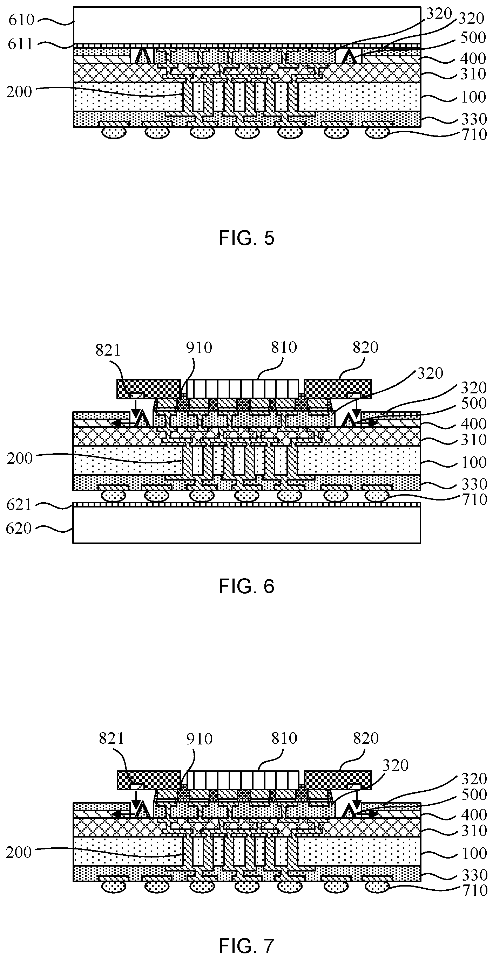

Next, referring to FIG. 1 and FIG. 5, step S5 is performed to thin the TSV base 100 to expose the second end of the TSV metal pillar 200.

Specifically, the second end of the TSV metal pillar 200 may be exposed by using, for example, a chemical mechanical polishing (CMP) process, and the TSV base 100 with a relatively flat surface is provided, to facilitate subsequent processes, and certainly, the TSV metal pillar 200 may also be exposed by using, for example, a mechanical grounding process.

Then, step S6 is performed to form a third redistribution layer 330 on the second surface of the TSV substrate 100, and the third redistribution layer 330 is electrically connected to the second end of the TSV metal pillar 200.

Then, step S7 is performed to form first metal bumps 710 on the third redistribution layer 330, and the first metal bumps 710 are electrically connected to the third redistribution layer 330.

Specifically, the third redistribution layer 330 may be an organic redistribution layer, that is, the material of the dielectric layer of the third redistribution layer 330 may comprise PI. The number of layers, layout, and fabrication method of the third redistribution layer 330 may be selected as required.

The first metal bumps 710 may comprise C4 metal bumps.

Next, referring to FIG. 1 and FIG. 6, step S8 is performed to remove the first supporting substrate 610, a second supporting substrate 620 is provided, and the first metal bumps 710 are bonded to the second supporting substrate 620.

Specifically, the second supporting substrate 620 may comprise a glass substrate, a metal substrate or a semiconductor substrate to provide support for subsequent processing steps. To facilitate subsequent removal of the second supporting substrate 620, in this embodiment, a second separation layer 621 is preferably formed on a surface of the second supporting substrate 620, and the second separation layer 621 comprises an adhesive tape and a polymer layer, for example, the second separation layer 621 may comprise a light-to-heat conversion layer, so that the second separation layer 621 may be subsequently heated by using, for example, laser, to remove the second supporting substrate 620, thereby improving operation convenience.

Then, step S9 is performed to bond an electrical chip 810 and an optical chip 820 on the second redistribution layer 320, where the electrical chip 810 and the optical chip 820 are both electrically connected to the second redistribution layer 320, and the photosensitive region 821 of the optical chip 820 is disposed corresponding to the micro-mirrors 500, so that the micro-mirrors 500 and the photosensitive region 821 can perform optical transmission.

Specifically, preferably, both the electrical chip 810 and the optical chip 820 are electrically connected to the second redistribution layer 320 by Flip-Chip, and the types of the electrical chip 810 and the optical chip 820 are not excessively limited herein.

Preferably, a first bottom filling layer 910 filling gaps may also be formed between the electrical chip 810, the optical chip 820 and the second redistribution layer 320 to form a protective layer, thereby improving the bonding strength and avoiding the influence of moisture, gas and the like. The material of the first underfill layer 910 may be selected as required, as long as it is an insulating material.

Next, referring to FIG. 1 and FIG. 7, step S10 is performed to remove the second supporting substrate 620.

As an example, in the case of wafer level preparation, after the second supporting substrate 620 is removed, a wafer cutting step may be performed to divide the wafer-level structure into a single structure as shown in FIG. 7, and the cutting process is not limited herein.

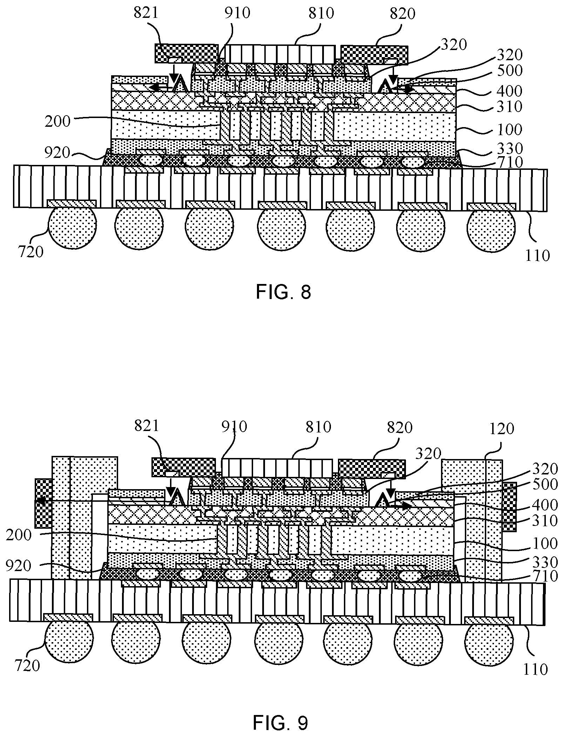

Next, referring to FIG. 8, a base substrate 110 is provided, the first metal bumps 710 are bonded to the base substrate 110, and the base substrate 110 is electrically connected to the first metal bumps 710.

As an example, referring to FIG. 8, after the first metal bumps 710 are bonded to the base substrate 110, a second underfill layer 920 filling a gap may be formed between the third redistribution layer 330 and the base substrate 110 to form a protective layer, thereby improving the bonding strength and avoiding the influence of moisture, gas and the like. The material of the second underfill layer 920 may be selected as required, as long as it is an insulating material.

Further, after the first metal bumps 710 are bonded to the base substrate 110, a carrier may be further provided to form second metal bumps 720 on the surface of the base substrate 110 to facilitate subsequent electrical extraction.

Next, referring to FIG. 1 and FIG. 9, step S11 is performed to provide a connector 120 and bond the connector 120 to the base substrate 110. The connector 120 is disposed corresponding to the optical waveguide wiring layer 400 to realize optical transmission. The specific type of the connector 120 is not limited herein.

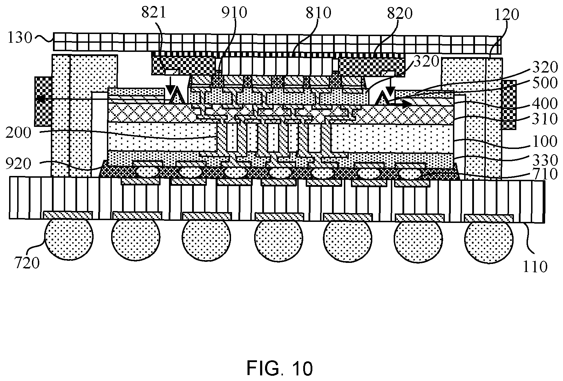

Further, referring to FIG. 10, the method may further comprise a step of providing a heat dissipation member 130 and bonding the heat dissipation member 130, where the bonded heat dissipation member 130 may be in direct and/or indirect contact with the electrical chip 810 and/or the optical chip 820.

Specifically, the heat dissipation member 130 may comprise an aluminum heat dissipation cover plate or a heat dissipation cover plate made of another material, for example, iron or copper. The heat dissipation member 130 may be in direct contact with the electrical chip 810 and/or the optical chip 820 or may be in indirect contact, so that effective heat dissipation can be performed through the heat dissipation member 130.

Referring to FIG. 2 to FIG. 10, the present disclosure further provides an optoelectronic integrated semiconductor packaging structure, which can be directly fabricated by the above preparation process. Accordingly, the materials, fabrication methods, and other aspects of the semiconductor packaging structure can be referred to the above content. Of course, the optoelectronic integrated semiconductor packaging structure can also be fabricated by other preparation processes as required.

Specifically, in this embodiment, the optoelectronic integrated semiconductor packaging structure comprises a TSV substrate 100, a first redistribution layer 310, an optical waveguide wiring layer 400, micro-mirrors 500, a second redistribution layer 320, a third redistribution layer 330, first metal bumps 710, an electrical chip 810, an optical chip 820, a base substrate 110, and a connector 120.

The first surface of the TSV substrate 100 exposes the first end of the TSV metal pillar 200; the first redistribution layer 310 is located on the first surface of the TSV substrate 100, and the first redistribution layer 310 is electrically connected to the first end of the TSV metal pillar 200; and the patterned optical waveguide wiring layer 400 is located on the first redistribution layer 310. The micro-mirrors 500 are located on the first redistribution layer 310, and the optical waveguide wiring layer 400 is disposed corresponding to the micro-mirrors 500; and the second redistribution layer 320 is located on the first redistribution layer 310 and is electrically connected to the first redistribution layer 310, and covers the optical waveguide wiring layer 400 but it does not cover the micro-mirrors 500. The third redistribution layer 330 is located on the second surface of the TSV substrate 100, and the third redistribution layer 330 is electrically connected to the second end of the TSV metal pillar 200; the first metal bumps 710 are located on the third redistribution layer 330 and is electrically connected to the third redistribution layer 330. The electrical chip 810 and the optical chip 820 are both bonded on the second redistribution layer 320, the electrical chip 810 and the optical chip 820 are both electrically connected to the second redistribution layer 320, and the photosensitive region 821 of the optical chip 820 is disposed corresponding to the micro-mirrors 500. The base substrate base 110 is bonded to the first metal bumps 710, and the base substrate 110 is electrically connected to the first metal bumps 710; the connector 120 is bonded to the base substrate 110, and the connector 120 is disposed corresponding to the optical waveguide wiring layer 400.

Further, the surface of the base substrate 110 may comprise second metal bumps 720 to facilitate subsequent electrical extraction.

Further, a first underfill layer 910 may be provided between the electrical chip 810, the optical chip 820, and the second redistribution layer 320 to form a protective layer to improve the bonding strength and avoid the influence of moisture, gas, etc.; and a second underfill layer 920 filling gaps may be further provided between the third redistribution layer 330 and the base substrate 110 to form a protective layer to improve the bonding strength and avoid the influence of moisture, gas, etc.

Further, a heat dissipation member 130 may be comprised, and the heat dissipation member 130 may be in direct and/or indirect contact with the electrical chip 810 and/or the optical chip 820, to perform effective heat dissipation by using the heat dissipation member 130.

In summary, in the optoelectronic integrated semiconductor packaging structure and the method for manufacturing the same of the present disclosure, the optical chip and the electrical chip are packaged through the TSV substrate, the supporting substrates, the redistribution layers, the optical waveguide wiring layer and the micro-mirrors, so that the electrical signal wiring and the optical signal wiring can be stacked and interconnected and staggered to reduce the packaging area, increase the wiring density, effectively shorten the transmission path of the optical signal and the electrical signal, reduce the signal attenuation, and meet the requirements of high-density integrated packaging.

The above embodiments are merely illustrative of the principles and effects of the present disclosure, and are not intended to limit the present disclosure. Any person skilled in the art can make modifications or changes to the above embodiments without departing from the spirit and scope of the present disclosure. Therefore, all equivalent modifications or changes made by those skilled in the art without departing from the spirit and technical idea of the present disclosure should still be covered by the claims of the present disclosure.

## Claims

1. A method for manufacturing an optoelectronic integrated semiconductor packaging structure, comprising:
providing a TSV substrate comprising a TSV metal pillar , wherein a first surface of the TSV substrate exposes a first end ofthe TSV metal pillar;
forming a first redistribution layer on the first surface of the TSV substrate, wherein the first redistribution layer is electrically connected to the first end of the TSV metal pillar;
forming a patterned optical waveguide wiring layer and micro-mirrors, and forming a second redistribution layer on the first redistribution layer, wherein the second redistribution layer is electrically connected to the first redistribution layer, the optical waveguide wiring layer is disposed next to the micro-mirrors, and the second redistribution layer covers the optical waveguide wiring layer, but it does not cover the micro-mirrors;
providing a first supporting substrate, and bonding the second redistribution layer to the first supporting substrate;
thinning a second surface of the TSV substrate to expose a second end of the TSV metal pillar;
forming a third redistribution layer on the thinned second surface of the TSV substrate, wherein the third redistribution layer is electrically connected to the second end of the TSV metal pillar;
forming first metal bumps on the third redistribution layer, wherein the first metal bumps are electrically connected to the third redistribution layer;
removing the first supporting substrate, providing a second supporting substrate, and bonding the first metal bumps to the second supporting substrate;
bonding an electrical chip and an optical chip on the second redistribution layer, wherein both the electrical chip and the optical chip are electrically connected to the second redistribution layer, and a photosensitive region of the optical chip is disposed corresponding to the micro-mirrors;
removing the second supporting substrate, providing a substrate, bonding the first metal bumps to the base substrate, and electrically connecting the base substrate to the first metal bumps; and
providing a connector, and bonding the connector to the base substrate, wherein the connector is disposed corresponding to the optical waveguide wiring layer.

2. The method for manufacturing the optoelectronic integrated semiconductor packaging structure according to claim 1, wherein a method for forming the micro-mirrors comprises a semiconductor exposure and development patterning method or a bonding method.

3. The method for manufacturing the optoelectronic integrated semiconductor packaging structure according to claim 2, wherein the micro-mirrors are manufactured by a semiconductor exposure and development patterning method, and the micro-mirrors are formed simultaneously with the second redistribution layer.

4. The method for manufacturing the optoelectronic integrated semiconductor packaging structure according to claim 1, wherein a method for forming the optical waveguide wiring layer comprises a semiconductor exposure and development method, and the formed optical waveguide wiring layer comprises an organic polymer optical waveguide wiring layer, a silicon-based optical waveguide wiring layer, a lithium niobate optical waveguide wiring layer or a lithium borate optical waveguide wiring layer.

5. The method for manufacturing the optoelectronic integrated semiconductor packaging structure according to claim 1, further comprising a step of providing a heat dissipation member and bonding the heat dissipation member, wherein the bonded heat dissipation member is in direct or indirect contact with one or both of the electrical chip and the optical chip.

6. The method for manufacturing the optoelectronic integrated semiconductor packaging structure according to claim 1, wherein after removing the second supporting substrate, the method further comprises a step of wafer cutting.

7. The method for manufacturing the optoelectronic integrated semiconductor packaging structure according to claim 1, wherein a first underfill layer fills a gap among the electrical chip, the optical chip and the second redistribution layer; and wherein a second underfill layer fills a gap between the third redistribution layer and the base substrate.

8. The method for manufacturing the optoelectronic integrated semiconductor packaging structure according to claim 1, wherein the first redistribution layer comprises a damascene type redistribution layer; the second redistribution layer comprises an organic redistribution layer; and the third redistribution layer comprises an organic redistribution layer.

9. An optoelectronic integrated semiconductor packaging structure, comprising:
a TSV substrate comprising a TSV metal pillar, wherein a first surface of the TSV substrate exposes a first end of the TSV metal pillar;
a first redistribution layer, wherein the first redistribution layer is located on the first surface of the TSV substrate, and the first redistribution layer is electrically connected to the first end of the TSV metal pillar;
a patterned optical waveguide wiring layer, wherein the optical waveguide wiring layer is located on the first redistribution layer;
micro-mirrors located on the first redistribution layer, wherein the optical waveguide wiring layer is disposed next to the micro-mirrors;
a second redistribution layer, wherein the second redistribution layer is located on the first redistribution layer and is electrically connected to the first redistribution layer, and wherein the second redistribution layer covers the optical waveguide wiring layer, but it does not cover the micro-mirrors;
a third redistribution layer, wherein the third redistribution layer is located on the second surface of the TSV substrate, and the third redistribution layer is electrically connected to a second end of the TSV metal pillar;
first metal bumps, wherein the first metal bumps are located on the third redistribution layer and electrically connected to the third redistribution layer;
an electrical chip and an optical chip, wherein the electrical chip and the optical chip are both bonded on the second redistribution layer, and are both electrically connected to the second redistribution layer, and a photosensitive region of the optical chip is disposed aligned to the micro-mirrors;
a base substrate, wherein the base substrate is bonded to the first metal bumps and electrically connected to the first metal bumps; and
a connector, wherein the connector is bonded to the base substrate and disposed next to the optical waveguide wiring layer.

10. The optoelectronic integrated semiconductor packaging structure according to claim 9, further comprising a heat dissipation member, wherein the heat dissipation member is in direct or indirect contact with one or both of the electrical chip and the optical chip.
